# FASCICULE DE BREVET EUROPEEN

(11) **EP 0 908 843 B1**
(45) Date de publication et mention de la délivrance du brevet: **23.06.2004**
(21) Numéro de dépôt: 98203292.2
(22) Date de dépôt: 30.09.1998
(51) Int. Cl.: G06K 19/077

(54) **Carte électronique sans contacts et son procédé de fabrication**
Kontaktlose elektronische Karte und Verfahren zur Herstellung einer solchen Karte
Contactless electronic card and its manufacturing method

(30) Priorité: 07.10.1997 FR 9712475
(43) Date de publication de la demande: 14.04.1999
(73) Titulaire: Koninklijke Philips Electronics N.V., 5621 BA Eindhoven (NL)
(72) Inventeur: Launay, François, 75008 Paris (FR)
(74) Mandataire: Charpail, François

(56) Documents cités:
- EP-A- 0 688 051
- EP-A- 0 753 827
- EP-A- 0 790 667
- DE-A- 19 601 202
- DE-C- 19 543 426

## Description

La présente invention concerne une carte électronique comportant un support de carte électriquement isolant, qui supporte au moins un enroulement servant d'antenne pour le transfert d'information par effet inductif résultant d'un champ électromagnétique et un circuit intégré relié électriquement aux extrémités dudit enroulement.

L'invention concerne aussi un procédé de fabrication et d'assemblage d'une telle carte.

Depuis quelques années, dans le domaine du péage routier ou de la distribution par exemple, des systèmes de support de données utilisant des cartes magnétiques et des cartes électroniques sont devenus d'un usage courant. En particulier, un système de support de données très commode est celui des cartes électroniques sans contact qui permet d'émettre et de recevoir des signaux à distance relativement faible. Dans ce système, des ondes électromagnétiques, émises par un appareil interrogateur qui peut lire et écrire, provoquent une modification du champ magnétique à proximité d'une bobine formant antenne, aménagée dans un répondeur, qui est en l'occurrence une carte éléctronique sans contacts, pour fournir une tension induite dans la bobine formant antenne et la tension ainsi engendrée est utilisée comme source de courant.

Les cartes sans contacts de l'art connu sont d'une fabrication assez complexe du fait qu'elles comportent le plus souvent un module constitué par un circuit intégré et une bobine électriquement reliés, ce qui implique une série d'opérations préalables pour la réalisation du seul module. Avec ou sans module, ces cartes sont du type feuilleté, et comportent trois couches ou plus en matériau isolant superposées, alors que leur épaisseur est normalisée à 0,76 mm. La multiplication du nombre de couches à assembler rend cette épaisseur difficile à obtenir avec une bonne précision.

A titre de carte sans contacts ne comportant pas de module support préfabriqué des éléments électriques (circuit intégré et bobine) on cite la demande de brevet européen EP 0 737 935 A2, sauf à considérer que l'ensemble constitué par la couche 1 qui est assez mince et qui a la même surface que la carte et le circuit intégré et la bobine 6 qui lui sont attachés tout en étant fonctionnels (voir la figure 1A de ce brevet) constituent un module. On notera que, dans ce pseudo module la bobine s'étend dans un même plan qui est le plan supérieur de la couche 1. Pour terminer la carte afin que les éléments électriques soient protégés il est encore nécessaire d'appliquer selon toute la surface de la couche 1 une couche de matériau central isolant à l'état pâteux 9 pour noyer la bobine et le circuit intégré jusqu'à obtention d'une surface plane, et encore de recouvrir chaque côté de l'ensemble ainsi obtenu d'une feuille de protection.

Un but de l'invention est de réaliser une carte électronique sans contacts qui ne comporte pas de module intermédiaire afin de réduire le nombre d'opérations nécessaires à sa fabrication.

Un autre but de l'invention est de réduire à deux le nombre de couches ou de feuilles de matériau isolant nécessaires à sa fabrication.

Ces buts sont atteints et les inconvénients de l'art antérieur sont atténués grâce au fait que la carte électronique indiquée au premier paragraphe est remarquable en ce que ledit support de carte comporte, sur une face structurée, un logement sur les parois et le fond duquel passent les spires dudit enroulement qui sont formées par ailleurs sur ladite face structurée, lequel logement comporte aussi lesdites extrémités de l'enroulement, en ce que ledit logement contient aussi ledit circuit intégré contre lesdites spires, ledit logement étant par ailleurs comblé avec une résine de protection polymérisée, et en ce qu'une feuille en matériau isolant couvre ladite face structurée à laquelle elle est collée.

Pour l'obtention d'une telle carte électronique, un procédé est remarquable en ce qu'il comporte les étapes suivantes :
- la fabrication d'un logement dans ledit support sur une face dite face structurée,
- l'application sur ladite face structurée des spires dudit enroulement qui passent sur les parois et le fond dudit logement, ce dernier comportant aussi les extrémités de l'enroulement,
- la mise en place, dans ledit logement dudit circuit intégré,
- la réalisation des connexions électriques reliant les contacts du circuit intégré aux extrémités dudit enroulement,
- le comblement dudit logement avec une résine de protection qui est ensuite polymérisée,
- l'application par collage d'une feuille en matériau isolant contre ladite face structurée du support.

On obtient ainsi en un petit nombre d'opérations une carte électronique comportant seulement deux couches en matériau isolant et qui résiste bien aux tests de fatigue mécanique. L'application des spires peut se faire par l'utilisation d'une technologie MID qui permet l'application de pistes électriques, en une seule étape sur un support qui présente un relief, en l'occurrence la face structurée du support de carte qui comporte un logement dans lequel doivent passer les pistes. Dans la technologie MID, on préfère la technique d'emboutissage (ou estampage) à chaud de bandes métalliques, dite "hot foil embossing" en anglais. On peut atteindre des résolutions de 200 µm, par ce procédé qui est par ailleurs bon marché et s'insère bien dans une chaine d'assemblage.

Pour l'étape de réalisation des connexions électriques qui relient les contacts du circuit intégré aux extrémités de l'enroulement, plusieurs solutions sont envisageables.

Un mode de réalisation préféré de cette étape consiste en collage par colle non conductrice du circuit intégré, par sa base, au fond du logement, puis la soudure de fils conducteurs entre les contacts du circuit intégré et les extrémités de l'enroulement.

Un autre mode de réalisation préféré de cette même étape consiste en une technique de montage flip-chip du circuit intégré, les connexions étant réalisées par soudure, par colle isolante ou par colle conductrice en des points localisés, les contacts du circuit intégré étant munis de surépaisseurs (ou bumps en anglais). Selon une autre technique de montage flip-chip, les connexions sont réalisées par collage, associé à une pression, au moyen d'une colle à conduction électrique anisotrope, à l'état de film préformé ou de pâte, les contacts du circuit intégré étant démunis de surépaisseurs.

La réalisation du logement dans le corps de carte peut être réalisée par fraisage mais, de préférence, le support de carte est réalisé, avec son logement, selon une technique de moulage par injection et peut comporter des surépaisseurs au fond du logement aux emplacements prévus pour les extrémités de l'enroulement.

La description qui suit, en regard des dessins annexés, le tout donné à titre d'exemple non limitatif fera bien comprendre comment l'invention peut être réalisée.
La figure 1 est une vue en perspective d'une partie de la carte électronique selon l'invention avant assemblage.
La figure 2 est une vue en coupe avec arrachement d'un premier mode de réalisation de l'invention.
La figure 3 montre en coupe la structure d'une spire conductrice munie d'une colle réactivable à chaud, utilisable pour la réalisation d'une carte électronique selon l'invention.
La figure 4 montre, en perspective avec arrachement la création de surépaisseurs aux extrémités des pistes conductrices qui constituent l'enroulement.
La figure 5 montre vu de dessus avec arrachement un deuxième mode de réalisation de l'invention.
La figure 6 est une vue selon la coupe VI-VI de la figure 5, cette représentation étant la même que pour la figure 2.
La figure 7 représente, par une vue en coupe en partie arrachée, le détail d'un montage flip-chip préféré du circuit intégré par collage au moyen d'une colle à conduction anisotrope.

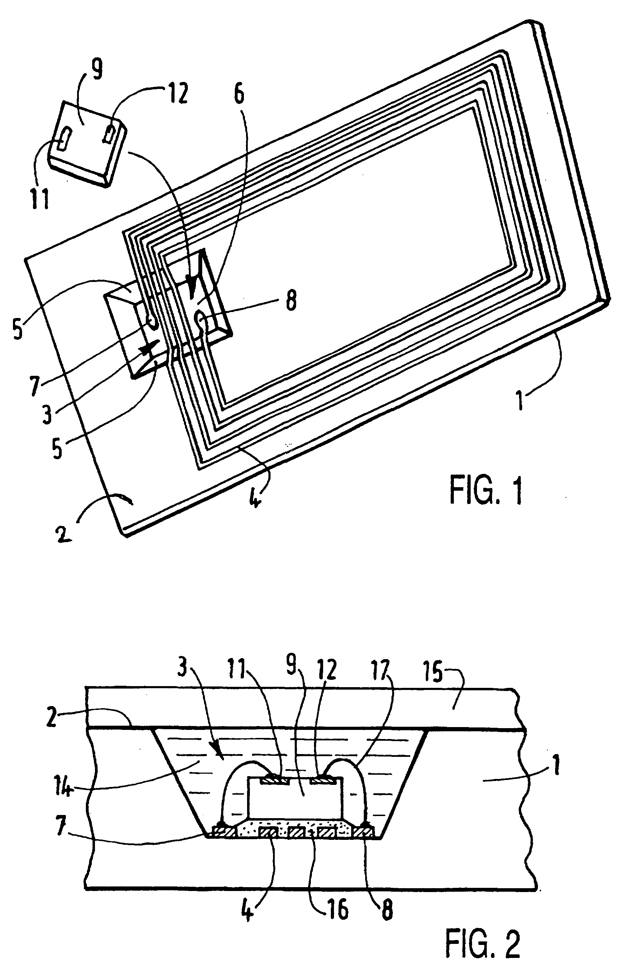

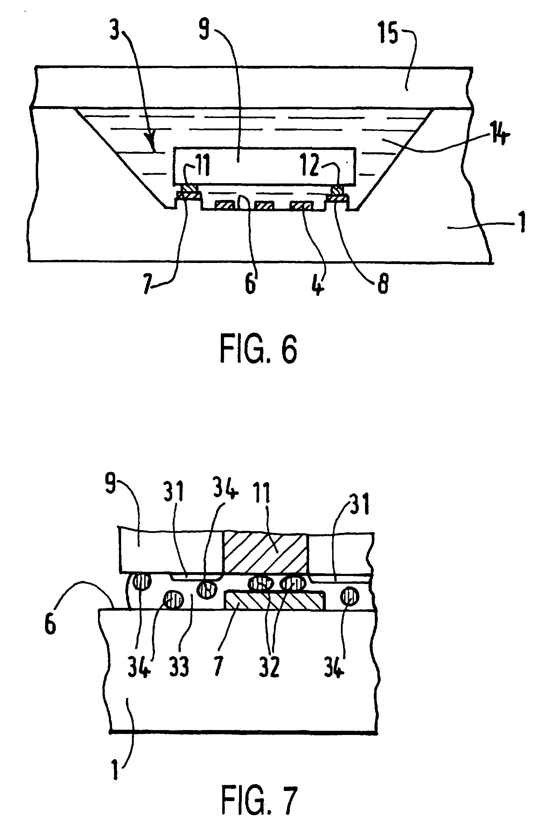

A la figure 1 est représenté le support 1 d'une carte électronique sans contacts. Le support 1, électriquement isolant est muni à sa face supérieure 2 dite structurée, d'un logement 3 et d'un enroulement conducteur 4 comportant plusieurs spires qui s'étendent sur la face 2 et qui, selon l'invention, traversent le logement 3 en passant sur des parois 5 et sur le fond 6 du logement 3. Les deux extrémités 7 et 8 de l'enroulement se situent au fond du logement 3. Par ailleurs, il est prévu qu'un circuit intégré (ou puce) 9 soit collé sur le fond 6 et que ses deux contacts 11 et 12 soient reliés électriquement aux extrémités 7, 8 de l'enroulement 4. Lorsque ces opérations sont terminées, le logement 3 est comblé avec une résine de protection 14 (voir figures 2 et 6) et une feuille en matériau isolant 15 par exemple en chlorure de polyvinyle (PVC), est collée sur la face structurée 2 (figures 2 et 6). La feuille 15 pourrait aussi être en polycarbonate ou en ABS. On notera que la feuille 15 et le support 1 sont, de préférence, constitués par le même matériau. Lorsque le support est constitué par de l'ABS ou du polycarbonate, le logement 3 y est réalisé par moulage par injection et lorsqu'il est en PVC, par lamage.

L'épaisseur du support 1 et de la feuille 15, et la profondeur du logement 3 sont choisies de façon telle que le circuit imprimé 9 se trouve sensiblement à mi-épaisseur de la carte électronique sans contacts, c'est-à-dire sur la fibre neutre, de façon à bien résister aux contraintes de flexions de la carte, lors de son utilisation. De préférence, les parois latérales 5 du logement sont légèrement inclinées. Le support 1 est réalisé, avec son logement 3, de préférence par moulage par injection d'une matière thermoplastique telle que de l'ABS, ou du polycarbonate. Il peut aussi être réalisé en PVC, auquel cas le logement 3 est obtenu par usinage. Le logement 3 doit avoir une prodondeur telle qu'une épaisseur de plastique suffisante, supérieure à 200 µm, soit laissée, en fond de carte pour éviter une cassure dudit fond de carte et protéger la puce électronique.

Divers procédés peuvent être utilisés pour solidariser les spires de l'enroulement 4, essentiellement en cuivre au support 1. Certains de ces procédés sont décrits plus loin. Un choix est aussi possible entre plusieurs procédés pour la réalisation des connexions électriques reliant les contacts du circuit intégré mis en place dans le logement auxdites extrémités de l'enroulement 4, au fond du logement, ce qui conduit à plusieurs modes de réalisation de l'invention.

Le mode de réalisation, classique, représenté à la figure 2, consiste à monter le circuit intégré 9, collé par sa base au moyen d'une couche polymérisable 16, généralement une colle époxy, au fond du logement 3, puis à souder des fils conducteurs 17, par exemple en or ou en aluminium, entre les contacts 11, 12 du circuit intégré 9 et les extrémités 7, 8 de l'enroulement 4. Divers procédés de montage et de câblage du circuit intégré sont bien connus de l'homme du métier et décrits dans de nombreuses publications, parmi lesquelles on peut citer les brevets FR 2 439 438, FR 2 548 857, EP 0 116 148, FR 2 520 541.

Pour ce qui est du câblage par soudure de fils conducteurs, des fils d'or ou d'aluminium peuvent être utilisés, quoique le fil d'or soit préféré pour des questions de rapidité (le procédé thermosonique utilisé pour la soudure des fils d'or est 3 à 4 fois plus rapide que la soudure des fils d'aluminium). Cette opération est la plus délicate du procédé d'assemblage car elle nécessite un préchauffage du support plastique. Comme il n'est pas souhaitable que ce préchauffage excède la température de transition vitreuse Tg du support plastique (risque de déformation), il est préférable d'utiliser des cartes réalisées dans des matériaux à fort Tg (polycarbonate, ABS, composés ABS-PVC, ou composés ABS-polycarbonate).

Après montage et collage de la puce, l'opération de remplissage du logement 3 peut être réalisée par un procédé simple dit de potting en anglais et qui consiste en le dépôt d'une goutte de résine 14 dans le logement 3. Afin d'obtenir une surface externe plane, on utilise de préférence des résines à très faible viscosité, telle par exemple la résine référencée 931-1 de la société américaine ABLESTICK. Cette résine doit posséder une haute pureté ionique et présenter une bonne résistance à l'absorption d'eau afin de protéger la puce électronique de façon efficace au cours des tests climatiques. Après application dans le logement, la résine est polymérisée, ce qui constitue l'avant dernière étape du procédé de fabrication et d'assemblage selon l'invention.

La dernière étape consiste en le collage par laminage, d'une feuille en PVC 15 sur la face structurée 2 du support.

Les procédés préférés pour l'application des spires de l'enroulement 4 sur le support 1 sur une surface non plane, dite 3D, sont :
- l'emboutissage à chaud d'une configuration de pistes (spires) collables, dit Hot Foil Embossing en anglais,
- le procédé de tampographie, suivi d'une métallisation par autocatalyse,
- la réalisation de pistes par lithogravure obtenue à partir d'hologrammes laser ou de masques tridimensionnels.

Parmi ces trois procédés les deux premiers sont bien connus et éprouvés, assez économiques, mais ne permettent pas d'obtenir une grande résolution pour la réalisation des pistes. Lorsqu'une grande résolution est requise, le troisième procédé, plus précis, peut être utilisé.

Les techniques de tampographie et de lithogravure sont compatibles avec la création de surépaisseurs aux extrémités 7, 8 de l'enroulement, réalisées au fond du logement lors du moulage par injection du support 1.

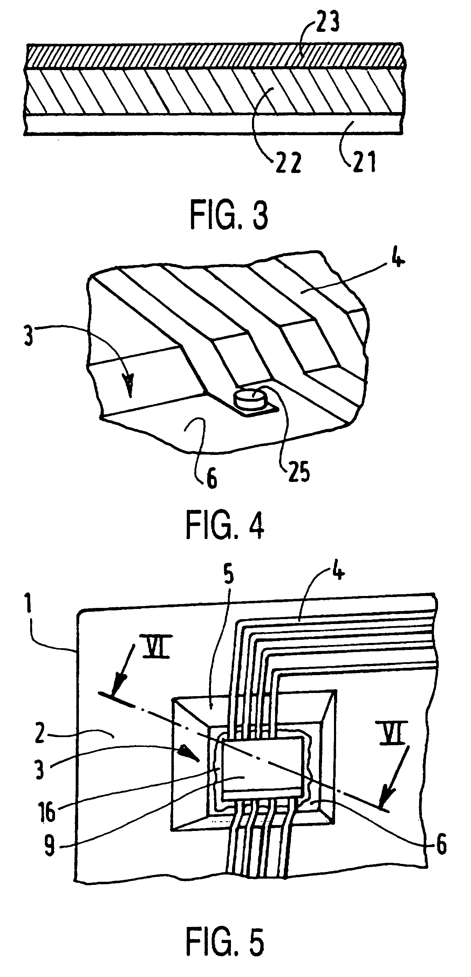

Concernant le procédé d'emboutissage (ou encore d'estampage) à chaud, on peut citer à titre d'exemple le contenu du brevet EP 0 063 347. Avec un cycle thermique d'une durée de l'ordre de 2 s, une configuration de pistes métalliques de 12 à 70 µm d'épaisseur peut être appliquée contre le support de carte, à l'endroit du logement 3 dont la forme est conçue à cet effet, c'est-à-dire avec parois inclinées de préférence, la pression d'application étant de l'ordre de 80 N/mm² et la température de l'ordre de 200°C. A cet effet, les feuilles d'estampage à chaud qui comportent les configurations de pistes ont la structure représentée à la figure 3 : une ou plusieurs couches de colle réactivable à chaud 21 (généralement à base de phénols) ayant une épaisseur de 1 à 4 µm, une couche de cuivre 22, assez ductile. d'épaisseur comprise entre 12 et 35 µm, et éventuellement une couche 23 d'étain ou de nickel de quelques µm d'épaisseur. La partie de la feuille qui n'est pas estampée peut ensuite être otée à partir d'une station d'enroulement avec du ruban adhésif.

Par le procédé de tampographie, avec une durée de cycle de 2 s, une laque contenant du palladium peut être imprimée contre le support de carte 1, contre les parois et le fond du logement 3 et autour de ce dernier sur la face 2, selon le dessin requis pour la configuration des spires métalliques à créer à cet endroit. La qualité de l'impression est bonne, puisqu'il est ainsi possible d'obtenir une précision de l'ordre de 50 µm pour la largeur des pistes conductrices aussi bien que pour la distance de séparation entre pistes.

La laque contenant du Pd, qui constitue un catalyseur et qui est déposée aux endroits adéquats sur le support 1, est ensuite chauffée à 100°C. Puis une métallisation (cuivre ou nickel), par autocatalyse est effectuée, cette dernière opération étant depuis longtemps connue et maîtrisée : le cuivre (nickel) ne se dépose, sur le support 1, qu'aux endroits où du catalyseur est présent. L'épaisseur de cuivre déposé est comprise entre 1 et 10 µm. Le principal avantage de ce procédé électrochimique de métallisation est que plusieurs milliers à plusieurs dizaines de milliers de cartes peuvent être traitées en même temps, plongées ensemble dans un même bain, en l'espace de quelques heures.

Lorsqu'une plus grande précision est nécessaire, pour le dessin des pistes conductrices dans le logement 3, il est possible d'utiliser un procédé de photolithographie, plus coûteux que les précédents. Cette technique est la transposition de la technique de photolithographie classique, pour la métallisation de surfaces planes, à la métallisation de surfaces gauches, en l'occurrence les parois et le fond du logement 3 et ses abords immédiats sur la face 2 du support. Pour cela, une technique connue de mise au point par masques 3D ou hologramme laser a été élaborée, qui consiste à réaliser l'image des pistes en 3D sur une surface qui coïncide avec celle du logement, ce qui permet d'obtenir la polymérisation d'un vernis seulement aux endroits voulus sur la surface du logement.

Par exemple, un procédé semi-additif peut être utilisé pour la réalisation des spires. Ce procédé, actuellement utilisé dans les principaux pays développés, consiste à effectuer un traitement du support plastique pour améliorer l'adhérence d'un dépôt métallique, du cuivre de préférence, sur lequel on fait ensuite croître des couches de contacts électriques en utilisant un masque de photorésist. Après exposition, le masque et les couches autour des contacts sont éliminés. Ce procédé permet donc des métallisations sur des supports non plans en utilisant des masques 3D ou des techniques au laser (génération d'hologrammes), et procure une résolution de l'ordre de 50 µm. Au moyen des différents procédés de métallisation précités, les contacts électriques ne sont plus supportés par un film, comme dans l'art antérieur, mais par le support de carte lui-même. De plus, les opérations de traversée d'un matériau isolant, pour l'établissement des contacts ne sont plus nécessaires.

Outre la technique de montage classique représentée à la figure 2, une technique de montage flip-chip décrite ci-dessous est préférée. Pour cela, les extrémités 7, 8 de l'enroulement 4 peuvent comporter des surépaisseurs dont la configuration est symétrique (par rapport à un plan) de celle des contacts de la puce avec lesquels elles doivent coopérer. De telles surépaisseurs, représentées schématiquement en 25 à la figure 4, sont réalisées de préférence lors du moulage du support de carte 1 : leur forme peut être cylindrique comme représenté à la figure 4, ou avoir l'aspect d'une calotte sphérique, et leur hauteur est de quelques dizaines de µm. La métallisation des surépaisseurs peut être effectuée en même temps que celle des spires de l'enroulement 4 par les procédés de tampographie ou lithogravure indiqués plus haut.

Selon des procédés connus, classiques, en technique de montage flip-chip, les contacts du circuit intégré, en aluminium doivent, préalablement au montage, être munis de surépaisseurs, en or ou en cuivre réalisées par dépôt galvanique, (ce qui implique une opération de reprise délicate du circuit intégré après sa fabrication) ou par soudure de "têtes de clous" en or à l'aide d'un équipement de soudure or thermosonique classique. Pour le montage, s'agissant de solidariser par paires les surépaisseurs de la puce et celles des extrémités de l'enroulement avec établissement d'un bon contact électrique, plusieurs procédés sont à disposition : le chauffage rapide de la puce associé à une pression, ce qui résulte en un brasage pour chaque paire de surépaisseurs ; ou bien l'application d'une pression associée à une vibration ultrasonore à 60 kHz induite par la presse qui supporte la puce (connue depuis longtemps pour la soudure de fils conducteurs). Un troisième procédé de connexion consiste à utiliser de la colle conductrice, par exemple une colle époxy chargée à 70 % d'argent, préalablement déposée sous forme de gouttelettes calibrées, ponctuellement, sur les surépaisseurs aux extrémités 7, 8 de l'enroulement 4, ou sur les surépaisseurs du composant par immersion desdites surépaisseurs dans un réservoir de colle. Ces techniques, classiques, sont représentées aux figures 5 et 6, la figure 6 étant la section selon la coupe VI-VI de la figure 5. Elles sont décrites plus en détail dans les demandes de brevet W0 92/13319 et W0 92/13320. Une colle isolante peut aussi être utilisée, qui ne nécessite pas un dépôt ponctuel sur les surépaisseurs métalliques réalisées sur les plages de métallisation du composant. Dans ce cas, une goutte de colle isolante est déposée au fond de la cavité, avant report du composant. Pendant la prépolymérisation de la colle, il est nécessaire d'appliquer une pression sur le composant pour obtenir un bon contact ohmique.

Une technique préférée de montage flip-chip, quoique plus délicate que celles indiquées au paragraphe précédent, est représentée à la figure 7. Dans ce cas, l'opération d'élaboration des surépaisseurs sur les contacts de la puce peut être économisée. Quant aux extrémités des spires conductrices 9 sur le fond 6 du logement 3, elles peuvent toujours comporter des surépaisseurs, de préférence, et, de préférence aussi, de forme cylindrique (25, figure 4).

La colle utilisée est une colle conductrice particulière dite anisotrope, déjà utilisée notamment pour le montage en surface de composants passifs. Ce type de colle contient des particules conductrices en faible concentration. Ces particules, élastiquement déformables, dont le diamètre est de l'ordre de 10 à 20 µm, permettent une conduction électrique lorsqu'elles sont pressées entre deux contacts, la colle restant isolante aux endroits où il n'y a pas de contacts. Des métallisations carrées de 100 µm de côté avec des espacements de 100 µm sont compatibles avec l'utilisation de ces colles en ce qui concerne l'aspect conduction (densité de particules se trouvant sur la métallisation au moment du collage -il faut en effet compter plusieurs particules, plutôt qu'une seule, qui serait théoriquement suffisante, pour l'établissement d'un bon contact-) et ne présentent pas de risque de court-circuit entre pistes conductrices. Ces colles sont actuellement disponibles sous forme de film (fabriquées par la société américaine 3M, ou la société japonaise HITACHI) ou sous forme de pâtes (fabriquées par les sociétés des Etats-Unis d'Amérique AIT et ZYMET, ou allemande LCD MIKROELECTRONIC). Des versions polymérisables au rayonnement ultraviolet sont disponibles. Pour la mise en oeuvre de l'invention, la colle anisotrope sous forme de pâte est préférée à celle sous forme de film. On notera que, pour l'utilisation de cette technique de connexion, un compromis doit être trouvé entre l'établissement d'une bonne conduction électrique au niveau de chaque contact de la puce et l'absence de courts-circuits dûs à des agglomérats de particules entre pistes. A contraintes de dimensionnement des contacts égales, ce compromis est d'autant plus facile à réaliser dans la mesure où il est possible d'augmenter la concentration en particules tout en diminuant leur taille. Mais pour que cette diminution de taille soit possible, il faut arriver à obtenir une bonne planéité de l'ensemble des extrémités des pistes sur le fond 6 du logement (celle des contacts du circuit intégré étant par ailleurs acquise). Un autre élément favorable à l'absence de courts-circuits entre pistes est la précision qu'il est possible d'obtenir pour la configuration des extrémités des pistes et pour le positionnement correct du circuit intégré lors du collage : une bonne précision, sous ces deux derniers aspects, permet de rendre les extrémités de pistes plus fines et donc d'augmenter la distance entre spires, ce qui diminue la probabilité de courts-circuits.

La figure 7 montre le détail des connexions par colle anisotrope. On a représenté le circuit intégré 9, avec l'un de ses contacts 11 en regard de l'extrémité 7 de l'enroulement et une couche de passivation superficielle 31 entre les contacts 11 et 12 ; le fond 6 du logement dans le support de carte 1, est muni des extrémités de pistes 7, 8, qui ne comportent pas de surépaisseurs en l'occurrence. Par collage, accompagné d'une certaine pression, des particules conductrices telles que 32 ont été emprisonnées dans la colle 33 puis comprimées entre les paires de contacts 7 et 11. D'autres particules, telles que 34 sont situées en dehors des contacts et ne participent à aucune conduction électrique. Pendant l'opération de collage le circuit intégré a été prépositionné de façon à ce que ses plages de métallisation (contacts) et les extrémités de l'enroulement 4 (avec ou sans surépaisseurs) soient en substance alignées. Une goutte de colle anisotrope a été déposée au fond du logement puis le circuit intégré a été déposé et pressé sur la colle. La polymérisation de la colle a ensuite été effectuée, soit à l'aide d'un four, soit par un système UV (dans le cas de résines réticulables aux UV).

Comme déjà décrit ci-dessus en référence à la figure 2, le logement 3 a été ensuite rempli (non représenté) par un simple procédé de potting. La simplicité de cette opération permet l'utilisation de systèmes remplissant plusieurs logements à la fois et donc l'obtention de capacités de production élevées par équipement. La résine utilisée est de préférence une résine de haute pureté ionique offrant une bonne résistance à l'absorption d'humidité et protégeant efficacement la puce de circuit intégré lors des flexions et des torsions de la carte.

Il faut noter que l'emploi d'une colle pour le collage de la puce et d'une résine de protection compatibles et possédant le même mode de polymérisation (thermique ou UV) permet de réaliser les opérations de collage de la puce et le remplissage du logement avec le même équipement. La séquence des opérations est alors la suivante :
- collage de la puce,
- remplissage du logement à l'aide d'un dispenseur de résine monté sur l'amenage de l'équipement de collage,
- polymérisation simultanée de la colle anisotrope du circuit intégré et de la résine d'enrobage. Dans cette éventualité, il est recommandé toutefois de prépolymériser la colle anisotrope avant son application sur le fond du logement. Dans ce cas, un seul équipement permet de réaliser l'intégralité du montage.

Après polymérisation de la résine qui comble le logement 3, la dernière opération consiste, comme pour le mode de réalisation de la figure 2, à coller une feuille en matériau isolant, en PVC, polycarbonate ou ABS, de préférence, sur la face structurée 2 du support 1. Cette opération peut être effectuée par laminage à froid ou à chaud.

Il est avantageux de réaliser plusieurs cartes sur un même support en forme de feuille ou en forme de bande, de réaliser toutes les opérations précitées, jusqu'au collage par laminage de la feuille en PVC, puis d'obtenir les cartes par découpe à la presse à partir de ce support commun.

En ce qui concerne la réalisation de surépaisseurs (ou bumps) sur les contacts du circuit intégré pour le mode de réalisation de la figure 6 (montage flip-chip classique), plusieurs options sont possibles :
- croissance par électrodéposition
- croissance par évaporation
- dispense
- impression
- soudure
Les quatre premiers procédés indiqués ci-dessus ont deux défauts :
- coûts trop élevés pour les circuits intégrés utilisés pour les cartes électroniques,
- insertion difficile dans une chaîne d'assemblage.

Le procédé préféré est celui de la soudure de surépaisseurs par un procédé de soudure fil thermosonique classique, à effectuer sur les plaques de circuit intégré avant sciage de celles-ci.

On notera que la carte électronique sans contacts pourrait comporter deux bobines dont l'une pour l'alimentation électrique et l'autre pour l'échange de données. L'invention reste applicable dans ce cas, les spires des deux bobines traversant le logement pour le circuit intégré et les extrémités des deux bobines étant situées au fond du logement. A noter aussi que l'invention est applicable à une carte mixte c'est-à-dire qui comporte à la fois des contacts pour transmission d'information par voie galvanique et au moins un enroulement pour transmission d'information par voie électromagnétique.

## Revendications

1. Carte électronique comportant un support de carte (1) électriquement isolant, qui supporte au moins un enroulement (4) servant d'antenne pour le transfert d'information par effet inductif résultant d'un champ électromagnétique et un circuit intégré (9) relié électriquement aux extrémités (7, 8) dudit enroulement, **caractérisée en ce que** ledit support de carte (1) comporte, sur une face structurée (2), un logement (3) sur les parois (5) et le fond (6) duquel passent les spires dudit enroulement (4) qui sont formées par ailleurs sur ladite face structurée (2), lequel logement comporte aussi lesdites extrémités (7,8) de l'enroulement, **en ce que** ledit logement contient aussi ledit circuit intégré, contre lesdites spires, ledit logement étant par ailleurs comblé avec une résine de protection (14) polymérisée, et **en ce qu'**une feuille (15) en matériau isolant couvre ladite face structurée (2) à laquelle elle est collée.

2. Procédé de fabrication et d'assemblage de carte électronique comportant un support de carte (1) électriquement isolant, qui supporte au moins un enroulement inductif (4) servant d'antenne et un circuit intégré (9) relié électriquement aux extrémités (7, 8) dudit enroulement, le procédé comportant les étapes suivantes :
- la fabrication d'un logement (3) dans ledit support (1) sur une face dite face structurée (2),
- l'application sur ladite face structurée des spires dudit enroulement qui passent sur les parois (5) et le fond (6) dudit logement, ce dernier comportant aussi les extrémités (7,8) de l'enroulement,
- la mise en place, dans ledit logement (3) dudit circuit intégré (9),
- la réalisation des connexions électriques (17,32) reliant les contacts du circuit intégré aux extrémités dudit enroulement,
- le comblement dudit logement avec une résine de protection (14) qui est ensuite polymérisée,
- l'application par collage d'une feuille (15) en matériau isolant contre ladite face structurée du support.

3. Procédé de fabrication et d'assemblage selon la revendication 2 selon lequel l'étape d'application des spires dudit enroulement sur ladite face structurée consiste en le collage par pression à chaud des spires munies d'une colle activable à chaud.

4. Procédé de fabrication et d'assemblage selon la revendication 2 ou 3, **caractérisé en ce que** ladite étape de réalisation des connexions électriques consiste en le collage par colle non conductrice (16) du circuit intégré, par sa base, au fond dudit logement, puis la soudure de fils conducteurs (17) entre les contacts (11,12) du circuit intégré et les extrémités (7,8) dudit enroulement.

5. Procédé de fabrication et d'assemblage selon la revendication 2 ou 3, **caractérisé en ce que** ledit support de carte est réalisé, avec son logement, selon une technique de moulage par injection et comporte des surépaisseurs au fond du logement aux emplacements prévus pour les extrémités dudit enroulement.

6. Procédé de fabrication et d'assemblage selon l'une des revendications 2, 3 ou 5, **caractérisé en ce que** ladite étape de réalisation des connexions électriques consiste en une technique de montage flip-chip du circuit intégré, lesdites connexions étant réalisées par soudure, par colle isolante, ou par colle conductrice en des points localisés, les contacts du circuit intégré étant munis de surépaisseurs.

7. Procédé de fabrication et d'assemblage selon l'une des revendications 2, 3 ou 5, **caractérisé en ce que** ladite étape de réalisation des connexions électriques consiste en une technique de montage flip-chip du circuit intégré, lesdites connexions étant réalisées par collage, associé à une pression, au moyen d'une colle à conduction électrique anisotrope (33) à l'état de film préformé ou de pâte, les contacts du circuit intégré étant démunis de surépaisseurs.

8. Procédé de fabrication et d'assemblage selon la revendication 7, **caractérisé en ce que** ladite colle à conduction électrique anisotrope est prépolymérisée avant l'étape de réalisation des connexions électriques et que sa polymérisation finale est simultanée à celle de ladite résine de protection.

## Patentansprüche

1. Elektronische Karte mit einem elektrisch isolierenden Kartenträger (1), der mindestens eine Spule (4) aufnimmt, welche als Antenne für die Übertragung von Informationen durch Induktivwirkung kommend aus einem elektromagnetischen Feld dient, und eine integrierte Schaltung (9), die elektrisch mit den Enden (7, 8) der besagten Spule verbunden ist, **dadurch gekennzeichnet, dass** der besagte Kartenträger (1) auf einer strukturierten Seite (2) eine Senkung (3) an den Wänden (5) und am Boden (6) aufweist, an dem die Wicklungen der besagten Spule (4) verlaufen, die außerdem auf der besagten strukturierten Fläche (2) gebildet werden, wobei die Senkung auch die Besagten Enden (7, 8) der Spule enthält, dadurch, dass die besagte Senkung auch die besagte integrierte Schaltung gegen die besagten Wicklungen enthält, die besagte Senkung außerdem mit einem polymerisierten Schutzharz (14) gefüllt wird und dadurch, dass eine Folie (15) aus Isoliermaterial die besagte strukturierte Fläche (2), auf die sie geklebt ist, abdeckt.

2. Verfahren für die Herstellung und den Zusammenbau einer elektronischen Karte mit einem elektrisch isolierenden Kartenträger (1), der mindestens eine induktive Spule (4) aufnimmt, welche als Antenne dient, und eine integrierte Schaltung (9), die elektrisch mit den Enden (7, 8) der besagten Spule verbunden ist, wobei das Verfahren folgende Schritte umfasst:
- die Herstellung einer Senkung (3) in den besagten Träger (1) auf eine sogenannte strukturierte Fläche (2),
- die Aufbringung auf die besagte strukturierte Fläche der Wicklungen der besagten Spule, die an den Wänden (5) und am Boden (6) der besagten Senkung verlaufen, wobei dieser letztere auch die Enden (7, 8) der Spule enthält,
- die Anbringung in der besagten Senkung der besagten integrierten Schaltung (9),
- die Herstellung der elektrischen Anschlüsse (17, 33) zur Verbindung der Kontakte der integrierten Schaltung mit den Enden der besagten Spule,
- die Füllung der besagten Senkung mit einem Schutzharz (14), welches danach polymerisiert wird,
- die Aufbringung durch Kleben einer Folie (15) aus Isoliermaterial gegen die besagte strukturierte Fläche des Trägers.

3. Verfahren für die Herstellung und den Zusammenbau nach Anspruch 2, nach dem der Schritt zur Anbringung der Windungen der besagten Wicklung auf die besagte strukturierte Fläche aus dem Warmleimen der Windungen mit einem warm reagierenden Klebstoff besteht.

4. Verfahren für die Herstellung und den Zusammenbau nach Anspruch 2 oder 3, **dadurch gekennzeichnet, dass** der besagte Schritt zur Herstellung der elektrischen Anschlüsse aus dem Kleben der Basis der integrierten Schaltung mit nichtleitendem Klebstoff (16) auf den Boden der Aussparung und dann aus dem Anlöten der leitenden Drähte (17) zwischen den Kontakten (11, 12) der integrierten Schaltung und den Enden (7, 8) der Spule besteht.

5. Verfahren für die Herstellung und den Zusammenbau nach Anspruch 2 oder 3, **dadurch gekennzeichnet, dass** der besagte Kartenträger mit seiner Senkung mit einer Spritzgusstechnik hergestellt wird und er an den für die Enden der Spule vorgesehenen Stellen am Boden der Senkung Überdicken aufweist.

6. Verfahren für die Herstellung und den Zusammenbau nach einem der Ansprüche 2, 3 oder 5, **dadurch gekennzeichnet, dass** der besagte Schritt zur Herstellung der elektrischen Anschlüsse aus einer Flip-Chip-Montagetechnik der integrierten Schaltung besteht, wobei die Verbindungen durch Anlöten, mit isolierendem Klebstoff oder leitendem Klebstoff an lokalisierten Punkten hergestellt werden und die Kontakte der integrierten Schaltung mit Überdicken versehen sind.

7. Verfahren für die Herstellung und den Zusammenbau nach einem der Ansprüche 2, 3 oder 5, **dadurch gekennzeichnet, dass** Verfahren für die Herstellung und den Zusammenbau nach einem der Ansprüche 2, 3 oder 5, **dadurch gekennzeichnet, dass** der besagte Schritt zur Herstellung der elektrischen Anschlüsse aus einer Flip-Chip-Montagetechnik der integrierten Schaltung besteht, wobei die Verbindungen durch Ankleben zusammen mit einem gewissen Druck mittels einem anisotropen elektrisch leitenden Klebstoff (33) aus einer vorgeformten Film- oder Pastenart hergestellt werden und die Kontakte der integrierten Schaltung frei von Überdicken sind.

8. Verfahren für die Herstellung und den Zusammenbau nach Anspruch 7, **dadurch gekennzeichnet, dass** der besagte anisotrope elektrisch leitende Klebstoff vor dem Schritt zur Herstellung der elektrischen Anschlüsse einer Vorpolymerisation unterzogen wird und seine Endpolymerisation zeitgleich mit der des Schutzharzes verläuft.

## Claims

1. A contactless electronic card comprising an electrically insulating card support (1) which supports at least a winding (4) used as an antenna for the transfer of information that results from an inductive effect of an electromagnetic field and an integrated circuit (9) electrically connected to the ends (7, 8) of said winding, **characterized in that** said card support (1) comprises on a structured surface (2) a cavity (3) on the walls (5) and bottom (6) of which the tracks of said winding (4) are found which are further formed on said structured surface (2), which cavity also includes said ends (7, 8) of the winding, **in that** said cavity also contains said integrated circuit against said tracks, said cavity further being filled up by a polymerized protective resin (14) and **in that** a foil (15) of insulating material covers said structured surface (2) to which it is glued.

2. A manufacturing and assembling method for a contactless electronic card, comprising an electrically insulating card support (1) which supports at least an inductive winding (4) used as an antenna and an integrated circuit (9) electrically connected to the ends (7, 8) of said winding, the method comprising the following steps:
- providing a cavity (3) in said support (1) on a surface called structured surface (2),
- applying on said structured surface the tracks of said winding which run on the walls (5) and the bottom (6) of said cavity, the latter also including the ends (7, 8) of the winding,
- positioning said integrated circuit (9) in said cavity (3),
- establishing the electric connections (17, 33) connecting the contacts of the integrated circuit to the ends of said winding,
- filling said cavity with a protective resin (14) which is then polymerized,
- applying a foil (15) of insulating material against said structured surface of the support by bonding.

3. A manufacturing and assembling method as claimed in claim 2 according to which the step of applying tracks of said winding on said structured surface consists of hot pressure gluing of the tracks that have a hot reactivable glue.

4. A manufacturing and assembling method as claimed in claim 2 or 3, **characterized in that** said step of establishing electric connections comprises gluing the integrated circuit with a non-conductive glue (16) by its base to the bottom of said cavity and then soldering the conductive wires (17) between the contacts (11, 12) of the integrated circuit and the ends (7, 8) of said winding.

5. A manufacturing and assembling method as claimed in claim 2 or 3, **characterized in that** said card support is made with its cavity according to an injection-molding technique and has bumps at the end of the cavity at the locations provided for the ends of said winding.

6. A manufacturing and assembling method as claimed in one of the claims 2, 3 or 5, **characterized in that** said step of establishing the electrical contacts consists of a flip-chip mounting technique of the integrated circuit, said connections being established by soldering, by insulation gluing or by conductive gluing at localized points, while the contacts of the integrated circuit have bumps.

7. A manufacturing and assembling method as claimed in one of the claims 2, 3 or 5, **characterized in that** said step of establishing the electrical contacts comprises a flip-chip mounting technique of the integrated circuit, said connections being established by gluing in combination with a pressure, by means of an anisotropic electrically conductive glue (33) in the form of pre-shaped foil or a paste in which case the contacts of the integrated circuit do not have bumps.

8. A manufacturing and assembling method as claimed in claim 7, **characterized in that** said anisotropic electrically conductive glue is prepolymerized before the step at which electric connections are established and **in that** its final polymerization is simultaneous with that of said protective resin.
